# EUROPEAN PATENT APPLICATION

(11) **EP 4 624 261 A1**
(43) Date of publication of application: **01.10.2025**
(21) Application number: 23895914.2
(22) Date of filing: 07.06.2023
(51) Int. Cl.: B60R 11/02, B60R 16/02, B60K 35/00, G01R 31/68, G06F 1/16

(54) **DISPLAY ASSEMBLY AND POSITION IDENTIFICATION METHOD THEREFOR, AND VEHICLE AND COMPUTER STORAGE MEDIUM**

(30) Priority: 30.11.2022 CN 202211535069
(71) Applicant: BYD Company Limited, Shenzhen, Guangdong 518118 (CN)
(72) Inventor: GUAN, Jinchang, Shenzhen, Guangdong 518118 (CN); LIU, Ke, Shenzhen, Guangdong 518118 (CN); JIN, Yingming, Shenzhen, Guangdong 518118 (CN)
(74) Representative: Taor, Simon Edward William
(86) International application number: PCT/CN2023/098913
(87) International publication number: WO 2024/113748

(57) **Abstract**

A display assembly (100) and a position identification method therefor, and a vehicle and a computer storage medium. The display assembly (100) comprises a wire harness (10) and a display (20), wherein the wire harness (10) comprises a first interface (11) and a second interface (12), and the display (20) comprises a first processor (21) and a connection interface (22). The first processor (21) comprises a detection pin (211), the detection pin (211) being connected to the connection interface (22). The connection interface (22) is adapted to connect to the first interface (11) of the wire harness (10). The wiring mode of the second interface (12) of the wire harness (10) corresponds to the level of the detection pin (211), the level of the detection pin (211) being used for indicating a mounting position of the display (20). The position identification method for a display assembly (100) is applied to the display assembly (100). The wire harness (10) connected to the detection pin (211) of the display (20) is configured to have different wiring modes, and different wiring modes correspond to different mounting positions and make the detection pin (211) have different levels. The display assembly (100) can determine the mounting position of the display (20) by acquiring the level of the detection pin (211), so that a manual pairing operation is not required in the process of determining the position of the display (20).

## Description

### CROSS-REFERENCE TO RELATED APPLICATIONS

The present disclosure claims priority to Chinese Patent Application No. 202211535069.5, filed on November 30, 2022 and entitled "DISPLAY ASSEMBLY AND POSITION IDENTIFICATION METHOD THEREFOR, VEHICLE, AND COMPUTER STORAGE MEDIUM". The entire content of the above-referenced application is incorporated herein by reference.

### FIELD

The present disclosure relates to the field of vehicles, and more specifically, to a display assembly and a position identification method therefor, a vehicle, and a computer storage medium.

### BACKGROUND

With the intelligent development of vehicles, increasing attention is paid on intelligence and entertainment of a cockpit. Current rear screens launched by the industry not only have a display function, but also extend to vehicle control, multi-screen interconnection, and the like. In a case that multiple screens are used, defining a rear screen as a left screen and a right screen can cause instructions for different screens to be executed more precisely, thereby better improving user experience. For example, after a left rear screen is defined, if a vehicle control demand such as opening a window is initiated on the rear left screen, an instruction of opening a left rear window is executed.

Currently, left and right screens are usually defined through manual pairing with the rear screen. For example, after a rear screen is switched on, a user manually selects a left screen located on a left side of the rear screen. After the pairing succeeds, the screen is marked as a left screen. However, if the user mistakenly marks the screen for the first time, manual pairing needs to be re-performed. If the screen is replaced during maintenance, manual pairing also needs to be re-performed. As a result, screen identification is excessively complicated and cumbersome.

### SUMMARY

To resolve the foregoing technical problem, the present disclosure provides a display assembly and a position identification method therefor and a vehicle. A process of determining a position of a display does not need a manual pairing operation, which is very intelligent.

A first aspect of the present disclosure provides a display assembly. The display assembly includes a wire harness and a display. The wire harness includes a first interface and a second interface. The display includes a first processor and a connection interface. The first processor includes a detection pin. The detection pin is connected with the connection interface. The connection interface is configured to connect to the first interface of the wire harness. A wiring mode of the second interface of the wire harness corresponds to a level of the detection pin. The level of the detection pin is used for indicating a mounting position of the display.

A second aspect of the present disclosure provides a vehicle. The vehicle includes the foregoing display assembly.

According to the display assembly and the vehicle provided the present disclosure, the wire harness connected with the detection pin of the display is configured with different wiring modes. Different wiring modes correspond to different mounting positions and different levels of the detection pin. The display assembly can determine the mounting position of the display by obtaining the level of the detection pin. Therefore, the process of determining the position of the display does not need a manual pairing operation, which is very intelligent.

A third aspect of the present disclosure provides a position identification method for a display assembly. The display assembly includes a display and a wire harness. The wire harness includes a first interface and a second interface. The display includes a connection interface and a first processor. The first processor includes a detection pin. The detection pin is connected with the connection interface. The connection interface is configured to connect to the first interface of the wire harness. A wiring mode of the second interface of the wire harness corresponds to a level of the detection pin. The level of the detection pin is used for indicating a mounting position of the display. The position identification method for a display assembly includes the following steps. The level of the detection pin is obtained after the connection interface is connected to the first interface of the wire harness. A position of the display is determined based on the level of the detection pin.

The position identification method for a display assembly provided in the present disclosure is applied to the display assembly including the wire harness and the detection pin. The wire harness connected with the detection pin of the display is configured with different wiring modes. Different wiring modes correspond to different mounting positions and different levels of the detection pin. The display assembly can determine the mounting position of the display by obtaining the level of the detection pin. Therefore, the process of determining the position of the display does not need a manual pairing operation, which is very intelligent.

A fourth aspect of the present disclosure further provides a computer storage medium. The computer storage medium includes a processor and a memory. The memory stores a computer program. The computer program is configured to be invoked by the processor to perform the foregoing position identification method for a display assembly.

### BRIEF DESCRIPTION OF THE DRAWINGS

To describe the technical solutions more clearly, drawings that need to be used in implementations are briefly described below. Apparently, the drawings in the following description show only some implementations of the present disclosure. A person of ordinary skill in the art can derive other drawings from the drawings without creative efforts.
FIG. 1 is a structural block diagram of a display assembly according to an embodiment of the present disclosure;
FIG. 2 is a schematic diagram of a connection relationship between a processor and a connection interface and a wire harness according to an embodiment of the present disclosure;
FIG. 3 is a schematic diagram of an inner structure of a display according to an embodiment of the present disclosure;
FIG. 4 is a schematic diagram of an inner structure of a display according to another embodiment of the present disclosure;
FIG. 5 is a structural block diagram of a vehicle according to an embodiment of the present disclosure; and
FIG. 6 is a flowchart of a position identification method for a display assembly according to an embodiment of the present disclosure.

In the drawings:

| | |
|---|---|
| Display assembly | 100 |
| Wire harness | 10 |
| Display | 20 |
| First interface | 11 |
| Second interface | 12 |
| First processor | 21 |
| Connection interface | 22 |
| Detection pin | 211 |
| Configuration line | 13 |
| Configuration pin | 121 |
| Power supply terminal | 23 |
| Resistor | 24 |
| Vehicle | 200 |
| Second processor | 110 |
| Driver's seat | 151 |
| Front passenger seat | 152 |
| First preset function assembly | 130 |
| Second preset function assembly | 140 |

### DETAILED DESCRIPTION

The technical solutions in embodiments of the present disclosure are clearly and completely described in the following with reference to drawings in the embodiments of this application. Apparently, the described embodiments are merely some rather than all of the embodiments of the present disclosure. All other embodiments obtained by a person of ordinary skill in the art based on the embodiments of the present disclosure without making creative efforts shall fall within the protection scope of the present disclosure.

In the description of the present disclosure, the terms "first", "second", and the like are used to distinguish different objects, and are not used to describe a specific sequence. In addition, orientation or position relationships indicated by terms such as "up", "down", "inner", and the like are orientation or position relationships shown based on the drawings, and are merely used for ease of describing the present disclosure and simplifying the description, rather than indicating or implying that the device or element has a particular orientation or is constructed and operated in a particular orientation. Therefore, such terms should not be construed as limiting of the present disclosure.

In the description of the present disclosure, unless otherwise explicitly specified or defined, the term "connection" should be understood in a broad sense. For example, the connection may be a fixed connection, a detachable connection, or an integral connection; or may be a direct connection, an indirect connection through a middle medium, or internal communication between two elements; or may be a mechanical connection; or may be a mechanical connection. A person of ordinary skill in the art may understand the specific meanings of the foregoing terms in the present disclosure according to specific situations.

The diagrams provided in the following embodiments show the basic idea of the present disclosure only in a schematic manner, and only assemblies related to the present disclosure are shown in the diagrams, instead of being drawn according to quantities, shapes, and sizes of the assemblies during actual implementation. During the actual implementation, a configuration, a number of, and a proportion of the assemblies may be randomly changed, and the layout and configuration of the assemblies may be more complicated.

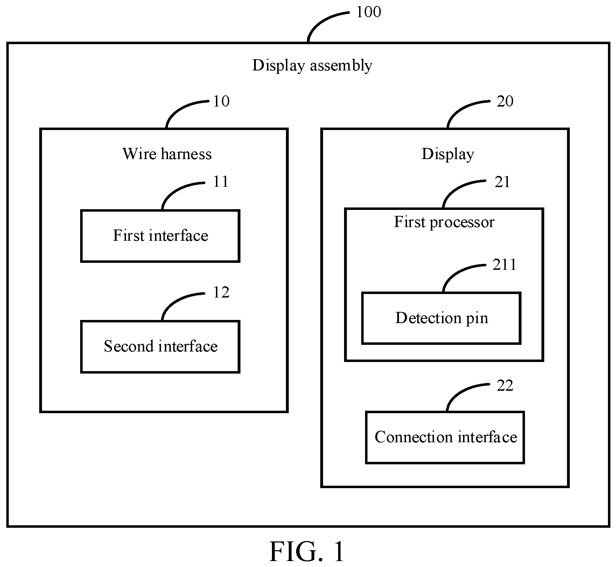

FIG. 1 is a structural block diagram of a display assembly 100 according to an embodiment of the present disclosure. As shown in FIG. 1, the display assembly 100 includes a wire harness 10 and a display 20. The wire harness 10 includes a first interface 11 and a second interface 12. The display 20 includes a first processor 21 and a connection interface 22. The first processor 21 includes a detection pin 211. The detection pin 211 is connected with the connection interface 22. The connection interface 22 is configured to connect to the first interface 11 of the wire harness 10. A wiring mode of the second interface 12 of the wire harness 10 corresponds to a level of the detection pin 211. The level of the detection pin 211 is used for indicating a mounting position of the display 20.

According to the display assembly 100 provided the present disclosure, the wire harness 10 connected with the detection pin 211 of the display 20 is configured with different wiring modes. Different wiring modes correspond to different mounting positions and different levels of the detection pin 211. The display assembly 100 can determine the mounting position of the display 20 by obtaining the level of the detection pin 211. Therefore, the process of determining the position of the display 20 does not need a manual pairing operation, which is very intelligent.

Different wiring modes of the second interface 12 of the wire harness 10 correspond to different mounting positions of the display 20. In other words, when the display 20 is mounted at different mounting positions, the wiring modes of the second interface 12 of the wire harness 10 to which the display 20 is connected are different. When the second interface 12 is connected in a different wiring mode, the level of the detection pin 211 is different. Therefore, a current mounting position of the display 20 may be determined based on the level of the detection pin 211. In other words, the level of the detection pin 211 may be used for indicating the mounting position of the display 20.

The first processor 21 may be configured to obtain the level of the detection pin 211.

In some embodiments, the wire harness 10 further includes a configuration line 13. The configuration line 13 is connected between the first interface 11 and the second interface 12, to cause the first interface 11 to be electrically connected to the second interface 12.

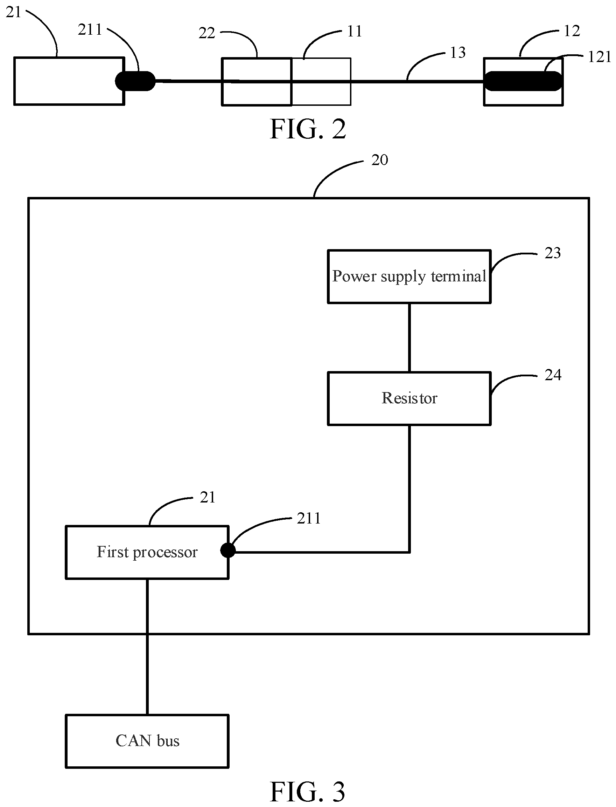

FIG. 2 is a schematic diagram of a connection relationship between a first processor 21 and a connection interface 22 and a wire harness 10 according to an embodiment of the present disclosure. In some embodiments, as shown in FIG. 2, the first interface 11 is connected with the connection interface 22. The second interface 12 includes a configuration pin 121. The configuration line 13 is connected between the configuration pin 121 and the first interface 11. The configuration pin 121 may be preconfigured to be suspended or grounded.

The configuration pin 121 may be grounded through connection to a ground terminal of the vehicle.

The connection interface 22 may include a first pin. The first pin is electrically connected to a detection pin 211 of the first processor 21. The first interface 11 may include a second pin. The second pin is connected with the configuration line 13. The second pin is configured to be connected to the first pin. When the connection interface 22 is connected to the first interface 11, the first pin is connected to the second pin. Therefore, the detection pin 211 is connected with the configuration line 13. The detection pin 211 is connected with the first interface 11.

In some embodiments, when the level of the detection pin 211 is a first level, the display 20 is in a first preset position. When the level of the detection pin 211 is a second level, the display 20 is in a second preset position.

In some embodiments, the first processor 21 determines that the display 20 is in the first preset position when the obtained level of the detection pin 211 is the first level, and determines that the display 20 is in the second preset position when the obtained level of the detection pin 211 is the second level. The first level is different from the second level.

In some embodiments of this application, the first level is a high level. The second level is a low level. The first processor 21 determines that the display 20 is in the first preset position when the obtained level of the detection pin 211 is the high level, and determines that the display 20 is in the second preset position when the obtained level of the detection pin 211 is a low level.

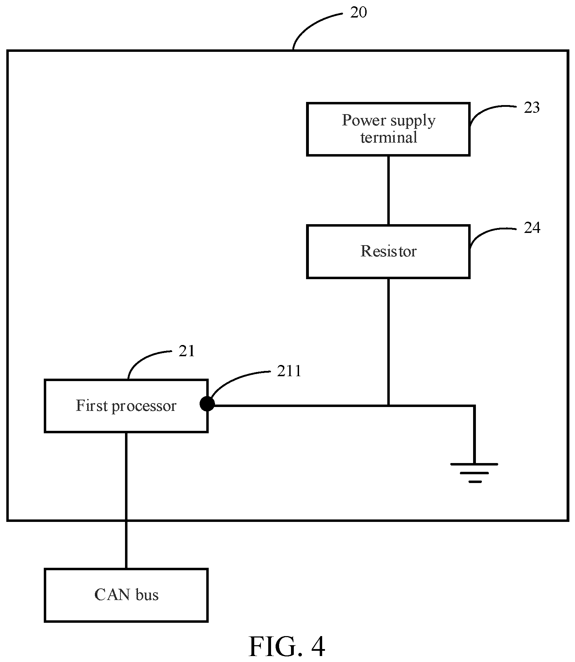

Referring to FIG. 3 and FIG. 4, FIG. 3 is a schematic diagram of an inner structure of a display 20 according to an embodiment of the present disclosure. FIG. 4 is a schematic diagram of an inner structure of a display 20 according to another embodiment of the present disclosure. As shown in FIG. 1, FIG. 3, and FIG. 4, in some embodiments, the display 20 further includes a power supply terminal 23 and a resistor 24. The resistor 24 is connected between the power supply terminal 23 and the detection pin 211. The power supply terminal 23 is configured to provide a high-level voltage. When the wiring mode of the second interface 12 is suspending the configuration pin 121, the level of the detection pin 211 is a high level. When the wiring mode of the second interface 12 is grounding the configuration pin 121, the level of the detection pin 211 is a low level.

As shown in FIG. 3, when the configuration pin 121 of the second interface 12 is configured to be suspended, the detection pin 211 of the first processor 21 obtains the high level from the power supply terminal 23 through the resistor 24. Therefore, the level of the detection pin 211 obtained by the first processor 21 is a first level.

When the configuration line 13 is suspended, a current is inputted to the first processor 21 by the power supply terminal 23 through the resistor 24 and the detection pin 211, so as to form a path. The first processor 21 may detect a constant voltage value, that is, the high level. Therefore, the first processor 21 determines that the display 20 is currently in the first preset position.

As shown in FIG. 4, when the configuration pin 121 of the second interface 12 is configured to be grounded, the detection pin 211 is grounded through the configuration pin 121 and is at a low level. Therefore, the level of the detection pin 211 obtained by the first processor 21 is a second level.

When the configuration line 13 is grounded, the detection pin 211 is equivalently grounded. The level of the detection pin 211 detected by the first processor 21 is 0, that is, the low level. Therefore, the first processor 21 determines that the display 20 is currently in the second preset position.

The power supply terminal 23 and the resistor 24 that are connected to the detection pin 211 are arranged, so that the high level can be provided to the detection pin 211 of the first processor 21 when the configuration pin 121 is suspended. The detection pin 211 is the low level when the configuration pin 121 is grounded. Therefore, the first processor 21 can determine a current position of the display 20 based on the level of the detection pin 211.

In some embodiments, the wire harness 10 may include a power supply line, which is configured to be connected to a power supply of the vehicle. When the wire harness 10 is connected to the connection interface 22, the power supply of the vehicle is connected to the power supply terminal 23 and supplies power to the power supply terminal. Therefore, the power supply terminal 23 can supply the high-level voltage.

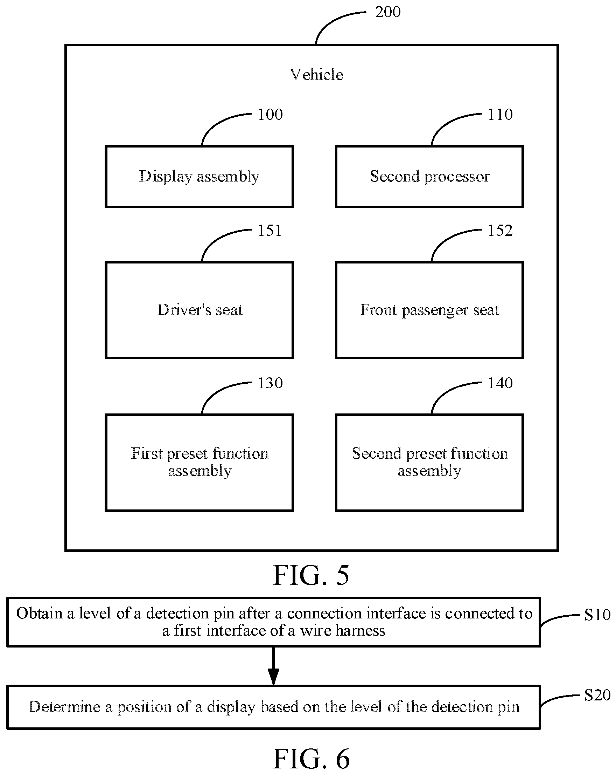

FIG. 5 is a structural block diagram of a vehicle 200 according to an embodiment of the present disclosure. In some embodiments, as shown in FIG. 5, the vehicle 200 includes the display assembly 100 according to any of the foregoing embodiments.

According to the vehicle 200 provided the present disclosure, the wire harness 10 connected with the detection pin 211 of the display 20 is configured with different wiring modes. Different wiring modes correspond to different mounting positions and different levels of the detection pin 211. The vehicle 200 can determine the mounting position of the display 20 by obtaining the level of the detection pin 211. Therefore, the process of determining the position of the display 20 does not need a manual pairing operation, which is very intelligent.

As shown in FIG. 5, the vehicle 200 includes a second processor 110. The second processor 110 is configured to: obtain first identification information corresponding to a first preset position of the display 20 transmitted by the first processor 21, and determine a position of the display based on the first identification information; and obtain second identification information corresponding to a second preset position of the display 20 transmitted by the first processor 21, and determine a position of the display based on the second identification information.

The second processor 110 determines that the display 20 is in the first preset position when the first identification information is obtained and determines that the display 20 is in the second preset position when the second identification information is obtained.

The second processor 110 may establish a communication connection with the first processor 21 of the display 20 through a controller area network (CAN) bus.

In some embodiments, when obtaining the level of the detection pin 211, the first processor 21 transmits the obtained level of the detection pin 211 to the second processor 110. When receiving the level of the detection pin 211, the second processor 110 determines a current position of the display 20. Specifically, the second processor 110 determines that the display 20 is in the first preset position when the received level of the detection pin 211 is a first level; and determines that the display 20 is in the second preset position when the received level of the detection pin 211 is a second level. In this embodiment, the current position of the display 20 is determined through the second processor 110.

The first identification information may be an identifier (ID) corresponding to the first preset position. The second identification information may be an ID corresponding to the second preset position.

As shown in FIG. 3 and FIG. 4, the first processor 21 is connected to the CAN bus. The first processor 21 may transmit a message including the first identification information to the second processor 110 through the CAN bus. After receiving the message, the second processor 110 determines that the display 20 is in the first preset position. Therefore, when the second processor 110 generates a control instruction in response to an input operation performed by a user on the display in the first preset position, the second processor 110 transmits the control instruction to the display 20 determined to be in the first preset position, so that the display 20 determined to be in the first preset position executes the control instruction. In addition, the second processor 110 may control, based on an instruction transmitted by the display 20 determined to be in the first preset position, a functional component in a vehicle corresponding to the first preset position to execute the instruction.

The first processor 21 may transmit a message including the second identification information to the second processor 110 through the CAN bus. After receiving the message, the second processor 110 determines that the display 20 is in the second preset position. Therefore, when the second processor 110 generates a control instruction in response to an input operation performed by a user on the display in the second preset position, the second processor 110 transmits the control instruction to the display 20 determined to be in the second preset position, so that the display 20 determined to be in the second preset position executes the control instruction. In addition, the second processor 110 may control, based on an instruction transmitted by the display 20 determined to be in the second preset position, a functional component in a vehicle corresponding to the second preset position to execute the instruction.

The identification information corresponding to the first preset position or the second preset position is transmitted to the second processor 110, so that the second processor 110 determines the current position of the display 20. Therefore, the second processor 110 may control, based on a demand of a user, the display 20 in different positions to perform corresponding operations. In addition, when the user performs an input operation on the display in different positions, the second processor 110 may control, based on an instruction transmitted by the display 20 in different positions, functional components corresponding to the different positions to execute the command.

The vehicle 200 further includes a power supply. The power supply may be connected to the second interface 12 of the wire harness 10 to supply power to the power supply terminal 23, so that the power supply terminal 23 can provide a high-level voltage.

The vehicle 200 further includes a ground terminal configured to be grounded. The ground terminal may be configured to be connected to the configuration pin 121, to cause the configuration pin 121 to be grounded.

As shown in FIG. 5, the vehicle 200 further includes a driver's seat 151 and a front passenger seat 152. The first preset position is a back of the driver's seat 151 of the vehicle 200, and the second preset position is a back of the front passenger seat 152 of the vehicle 200. Alternatively, the first preset position is the back of the front passenger seat 152 of the vehicle 200, and the second preset position is the back of the driver's seat 151 of the vehicle 200. The display 20 arranged on the back of the driver's seat 151 and the front passenger seat 152 may be operated and used by a passenger on a rear seat.

In another embodiment, the vehicle may include multiple seats. The first preset position and the second preset position may be a back or an armrest of any of the multiple seats.

In some embodiments, the vehicle 200 further includes a first preset function assembly 130 and a second preset function assembly 140. When the display 20 is in the first preset position, the first processor 21 is configured to generate a control instruction for the first preset function assembly 130 in response to an input operation of the display 20. When the display 20 is in the second preset position, the first processor 21 is configured to generate a control instruction for the second preset function assembly 140 in response to an input operation of the display 20.

Specifically, when the display 20 is in the first preset position, the first processor 21 generates the control instruction for controlling the first preset function assembly 130 in response to the input operation inputted on the display 20. When the display 20 is in the second preset position, the first processor 21 generates the control instruction for controlling the second preset function assembly 140 in response to the input operation inputted on the display 20.

The second processor 110 is further configured to: receive the control instruction for controlling the first preset function assembly 130 transmitted by the first processor 21 of the display 20; and control the first preset function assembly 130 to execute the control instruction when receiving the control instruction. The second processor 110 is further configured to: receive the control instruction for controlling the second preset function assembly 140 transmitted by the first processor 21 of the display 20; and control the second preset function assembly 140 to execute the control instruction when receiving the control instruction.

The display 20 may include a display screen. The display screen may be a touchscreen or a display screen with mechanical buttons. The display screen may be configured for a user to perform the input operation. The first processor 21 is configured to generate the control instruction in response to the input operation of a user.

When the first processor 21 transmits the first identification information to the second processor 110, the second processor 110 determines that the display 20 is in the first preset position, and controls the first preset function assembly 130 to perform a corresponding operation when receiving the control instruction transmitted by the first processor 21 for the first preset function assembly 130. When the first processor 21 transmits the second identification information to the second processor 110, the second processor 110 determines that the display 20 is in the second preset position, and controls the second preset function assembly 140 to perform a corresponding operation when receiving the control instruction transmitted by the first processor 21 for the second preset function assembly 140.

The display 20 provided in this embodiment of the present disclosure can generate control commands for controlling different preset function assemblies when being in different positions, so that the vehicle 200 can control a target function assembly in a targeted manner to perform a corresponding operation based on a current position of the current display 20. In this way, the display assembly 100 and the vehicle 200 can be used more intelligently.

Exemplarily, the first preset position is the back of the driver's seat 151, and the second preset position is the back of the front passenger seat 152, the first preset function assembly 130 is a left window, and the second preset function assembly 140 is a right window. When the display 20 is located on the back of the driver's seat 151 and the user inputs an operation of opening a window on the display 20, the first processor 21 of the display 20 generates a control instruction for controlling the left window to be opened in response to the input operation of opening a window, and transmits the control instruction to the second processor 110. When receiving the control instruction, the second processor 110 controls the left window to be opened. When the display 20 is located on the back of the front passenger seat 152 and the user inputs an operation of opening a window on the display 20, the first processor 21 of the display 20 generates a control instruction for controlling to the right window to be opened in response to the input operation of opening a window, and transmits the instruction to the second processor 110. When receiving the control instruction, the second processor 110 controls the right window to be opened.

In some embodiments, when the display 20 is in the first preset position, the first processor 21 is configured to: receive an instruction for controlling the display in the first preset position to perform a first operation generated by the second processor 110, and control the display 20 to perform the first operation. When the display 20 is in the second preset position, the first processor 21 is configured to: receive an instruction for controlling the display in the second preset position to perform a second operation generated by the second processor 110, and control the display 20 to perform the second operation.

In some embodiments, the vehicle 200 includes a front display screen for the user to perform the input operation. The second processor 110 is configured to generate a control instruction in response to the operation inputted by the user on the front display screen and transmit the control instruction to the first processor 21 of the display 20. The first processor 21 controls the display 20 to perform a corresponding operation when receiving the control instruction.

The second processor 110 is configured to: generate, in response to a first input operation inputted on the front display screen, an instruction for controlling the display in the first preset position to perform the first operation, and transmit the instruction to the first processor 21 of the display 20 in the first preset position. The first processor 21 controls the display 20 to perform the first operation when receiving the instruction. The second processor 110 is configured to: generate, in response to a second input operation inputted on the front display screen, an instruction for controlling the display in the second preset position to perform the second operation, and transmit the instruction to the first processor 21 of the display 20 in the second preset position. The first processor 21 controls the display 20 to perform the second operation when receiving the instruction.

Exemplarily, the first preset position is the back of the driver's seat 151. The second preset position is the back of the front passenger seat 152. The back of the driver's seat 151 and the back of the front passenger seat 152 are both provided with the display 20. When the user performs, on the front display screen, an input operation of sharing a video to the display of the back of the driver's seat 151, the second processor 110 generates, in response to the input operation, an instruction for controlling the display 20 in the first preset position to display the video, and transmits the instruction to the first processor 21 of the display 20 located at the back of the driver's seat 151. The first processor 21 controls the display 20 located on the back of the driver's seat 151 to display the video when receiving the instruction. The display 20 located at the back of the front passenger seat 152 does not display the video.

FIG. 6 is a flowchart of a position identification method for a display assembly according to an embodiment of the present disclosure. The position identification method for a display assembly is applied to the display assembly 100 according to any of the foregoing embodiments. As shown in FIG. 6, the position identification method for a display assembly includes the following steps.

S10: A level of the detection pin 211 is obtained after the connection interface 22 is connected to the first interface 11 of the wire harness 10.

S20: A position of the display 20 is determined based on the level of the detection pin 211.

The position identification method for a display assembly provided in the present disclosure is applied to the display assembly 100 including the wire harness 10 and the detection pin 211. The wire harness 10 connected with the detection pin 211 of the display 20 is configured with different wiring modes. Different wiring modes correspond to different mounting positions and different levels of the detection pin 211. The display assembly 100 can determine the mounting position of the display 20 by obtaining the level of the detection pin 211. Therefore, the process of determining the position of the display 20 does not need a manual pairing operation, which is very intelligent.

In some embodiments, the position identification method for a display assembly further includes the following steps. It is determined that the display 20 is in a first preset position when the obtained level of the detection pin 211 is a first level. It is determined that the display 20 is in a second preset position when the obtained level of the detection pin 211 is a second level. The first level is different from the second level.

In some embodiments, the configuration pin 121 is preconfigured to be suspended. That it is determined that the display 20 is in a first preset position when the obtained level of the detection pin 211 is a first level includes the following step. It is determined that the display 20 is in the first preset position when the obtained level of the detection pin 211 is a high level.

In some embodiments, the configuration pin 121 is preconfigured to be grounded. That it is determined that the display 20 is in a second preset position when the obtained level of the detection pin 211 is a second level includes the following step. It is determined that the display 20 is in the second preset position when the obtained level of the detection pin 211 is a low level.

Because the configuration pin 121 of the wire harness 10 is preconfigured to be suspended or grounded corresponding to different mounting positions, the current position of the display 20 may be determined based on the level of the detection pin 211.

The position identification method for a display assembly corresponds to the foregoing display assembly 100. For more detailed description, reference may be made to content of the embodiments of the foregoing display assembly 100. For the content of the position identification method for a display assembly and the content of the foregoing display assembly 100, reference may be made to each other.

An embodiment of the present disclosure provides a vehicle control method, which is applied to the vehicle 200 according to any of the foregoing embodiments. The vehicle control method includes the following steps. The position of the display 20 is determined through the foregoing position identification method for a display assembly. When the display 20 is in the first preset position, a control instruction for the first preset function assembly 130 is generated in response to the input operation inputted on the display 20. When the display 20 is in the second preset position, a control instruction for the second preset function assembly 140 is generated in response to the input operation inputted on the display 20.

In some embodiments, the vehicle control method further includes the following steps. When the display 20 is in the first preset position, the display 20 receives an instruction for controlling the display at the first preset position to perform a first operation generated by the second processor 110, and performs the first operation. When being in the second preset position, the display 20 receives an instruction for controlling the display at the second preset position to perform a second operation generated by the second processor 110, and performs the second operation.

The present disclosure further provides a computer storage medium. The computer storage medium includes a processor and a memory. The memory stores a computer program. The computer program is configured to be invoked by the processor to perform the foregoing position identification method for a display assembly according to any of the foregoing embodiments.

An embodiment of the present disclosure further provides a computer storage medium. The computer storage medium stores a computer program for electronic data interchange. The computer program causes the computer to perform some or all of the steps of any control method in the foregoing method embodiments.

An embodiment of the present disclosure further provides a computer program product. The computer program product includes a non-transitory computer-readable storage medium storing a computer program. The computer program is operable to cause a computer to perform some or all of the steps of any control method recorded in the foregoing method embodiments.

It should be noted that, to simplify the description, the foregoing method embodiments are described as a series of action combination, but a person of ordinary skill in the art is to know that the present disclosure is not limited to any described sequence of the action, because some operations may be performed in another sequence or simultaneously according to the present disclosure. In addition, a person skilled in the art is further to understand that the embodiments in the description are exemplary embodiments, and the involved actions and modules mentioned are not necessarily required by the present disclosure.

In the foregoing embodiments, the descriptions of each embodiment have different focuses, and for a part that is not described in detail in an embodiment, reference may be made to the relevant description of other embodiments.

The above are implementations of the embodiments of the present disclosure. It should be noted that a person of ordinary skill in the art may make several improvements and refinements without departing from the principles of the embodiments of the present disclosure. These improvements and refinements are considered to fall within the protection scope of the present disclosure.

## Claims

1. A display assembly (100), comprising:
a wire harness (10), comprising a first interface (11) and a second interface (12); and
a display (20), comprising a first processor (21) and a connection interface (22), the first processor (21) comprising a detection pin (211), the detection pin (211) being connected with the connection interface (22), the connection interface (22) being configured to connect to the first interface (11) of the wire harness (10), a wiring mode of the second interface (12) of the wire harness (10) corresponding to a level of the detection pin (211), and the level of the detection pin (211) being used for indicating a mounting position of the display (20).

2. The display assembly (100) according to claim 1, wherein when the level of the detection pin (211) is a first level, the display (20) is in a first preset position; and when the level of the detection pin (211) is a second level, the display (20) is in a second preset position.

3. The display assembly (100) according to claim 2, wherein the second interface (12) comprises a configuration pin (121); the display (20) further comprises a power supply terminal (23) and a resistor (24); the resistor (24) is connected between the power supply terminal (23) and the detection pin (211); the first level is a high level; the second level is a low level;
when the wiring mode of the second interface (12) is suspending the configuration pin, the level of the detection pin (211) is a high level; and when the wiring mode of the second interface (12) is grounding the configuration pin, the level of the detection pin (211) is a low level.

4. A vehicle (200), comprising the display assembly (100) according to any of claims 1 to 5.

5. The vehicle (200) according to claim 4, further comprising a second processor (110), the second processor (110) being configured to: obtain first identification information corresponding to a first preset position of the display (20) transmitted by the first processor (21), and determine a position of the display (20) based on the first identification information.

6. The vehicle (200) according to claim 4 or 5, further comprising a first preset function assembly (130) and a second preset function assembly (140), when the display (20) is in the first preset position, the first processor (21) being configured to generate a control instruction for the first preset function assembly in response to an input operation of the display (20), and when the display (20) is in the second preset position, the first processor (21) being configured to generate a control instruction for the second preset function assembly in response to an input operation of the display (20).

7. The vehicle (200) according to claim 5 or 6, wherein the first preset position is a back of a driver's seat (151) of the vehicle (200); and the second preset position is a back of a front passenger seat (152) of the vehicle (200).

8. The vehicle according to claim 5 or 6, wherein the first preset position is an armrest of a driver's seat (151) of the vehicle (200); and the second preset position is an armrest of a front passenger seat (152) of the vehicle (200).

9. A position identification method for a display assembly, the display assembly (100) comprising a display (20) and a wire harness (10), the wire harness (10) comprising a first interface (11) and a second interface (12), the display (20) comprising a connection interface (22) and a first processor (21), the first processor (21) comprising a detection pin (211), the detection pin (211) being connected with the connection interface (22), the connection interface (22) being configured to connect to the first interface (11) of the wire harness (10), a wiring mode of the second interface (12) of the wire harness (10) corresponding to a level of the detection pin (211), the level of the detection pin (211) being used for indicating a mounting position of the display (20), and the position identification method for a display assembly comprising:
obtaining the level of the detection pin after the connection interface (22) is connected to the first interface (11) of the wire harness (10) (S10); and
determining a position of the display (20) based on the level of the detection pin (211) (S20).

10. The position identification method for a display assembly according to claim 9, wherein the determining a position of the display (20) based on the level of the detection pin (211) comprises:
determining that the display (20) is in a first preset position when the obtained level of the detection pin (211) is a first level; and
determining that the display (20) is in a second preset position when the obtained level of the detection pin (211) is a second level.

11. The position identification method for a display assembly according to claim 10, wherein the display (20) further comprises a power supply terminal and a resistor; the resistor is connected between the power supply terminal and the detection pin (211); the first level is a high level; the second level is a low level; when the wiring mode of the second interface (12) is suspending a configuration pin, the level of the detection pin (211) is a high level; when the wiring mode of the second interface (12) is grounding configuration pin, the level of the detection pin (211) is a low level; the determining that the display (20) is in a first preset position when the obtained level of the detection pin (211) is a first level comprises:
determining that the display (20) is in the first preset position when the obtained level of the detection pin (211) is a high level; and
the determining that the display (20) is in a second preset position when the obtained level of the detection pin (211) is a second level comprises:
determining that the display (20) is in the second preset position when the obtained level of the detection pin (211) is a low level.

12. A computer storage medium, comprising a processor and a memory, the memory storing a computer program, the computer program being configured to be invoked by the processor to perform the position identification method for a display assembly according to any of claims 9 to 11.
